(19) Europäisches Patentamt
European Patent Office
Office européen des brevets

(11) **EP 2 837 258 B1**

(12) **EUROPEAN PATENT SPECIFICATION**

(45) Date of publication and mention
of the grant of the patent:
**20.01.2021   Bulletin 2021/03**

(51) Int Cl.:
**H01M 10/48** *(2006.01)*      **H05B 45/50** *(2020.01)*

(21) Application number: **13716267.3**

(22) Date of filing: **10.04.2013**

(86) International application number:
**PCT/EP2013/057475**

(87) International publication number:
**WO 2013/153107 (17.10.2013 Gazette 2013/42)**

(54) **BATTERY MONITORING IN EMERGENCY LIGHTING SYSTEMS**

BATTERIEÜBERWACHUNG IN NOTBELEUCHTUNGSSYSTEMEN

SURVEILLANCE DE BATTERIE DANS DES SYSTÈMES D'ÉCLAIRAGE DE SECOURS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.04.2012   GB 201206314**

(43) Date of publication of application:
**18.02.2015   Bulletin 2015/08**

(73) Proprietor: **Tridonic Uk Ltd**
**Chineham, Basingstoke RG24 8LB (GB)**

(72) Inventors:
• **WILSON, Ian**
**East Herrington**
**Sunderland SR3 3RH (GB)**
• **DIXON, David**
**Wallsend NE28 9QZ (GB)**

(74) Representative: **Rupp, Christian**
**Mitscherlich PartmbB**
**Patent- und Rechtsanwälte**
**Sonnenstraße 33**
**80331 München (DE)**

(56) References cited:
**DE-A1- 3 224 671       FR-A1- 2 622 749**
**GB-A- 2 088 159         GB-A- 2 271 229**
**US-A1- 2007 046 261   US-A1- 2011 267 000**
**US-B1- 6 313 609**

**Description**

TECHNICAL FIELD

The present invention relates to a battery condition monitoring system for an emergency lighting system and to a method of estimating battery condition for an emergency lighting system including performing a measurement to obtain an indication of battery impedance. The invention further relates to an emergency lighting system incorporating such a battery condition monitoring system.

BACKGROUND TO THE INVENTION

Document DE 32 24 671 A1 discloses monitoring means for lighting installations. Document FR 2 622 749 A1 discloses an independent emergency lighting device with self-diagnostics. Document US 6 313 609 B1 discloses determining battery capacity using one or more applications of a constant power load. Document US 2011/267000 A1 discloses a battery charging apparatus, an electronic apparatus and a charging method. Document GB 2 088 159 A discloses a battery charging apparatus. Document GB 2 271 229 A discloses monitoring the internal impedance of an accumulator battery in an uninterruptible power supply. Document US 2007/046261 A1 discloses a method and apparatus for temperature, conductance and/or impedance testing in remote application of battery monitoring systems.

A reduction of energy storage capacity of batteries occurs due to degrading and/or aging. This can be problematical in some applications such as emergency lighting, where the correct level of battery capacity is essential for safety reasons (e.g. to provide illumination of emergency lamps at sufficient intensity and for sufficient duration to allow evacuation of a building). It is desirable to know when battery energy storage capacity is reduced below a minimum value so that the batteries can be replaced before their energy storage capacity becomes unacceptably low.

Load cycle testing is one method for energy storage capacity testing. Load cycle testing is the discharge of a battery at a constant current or power to a specified terminal voltage, during which the voltages of each battery are monitored for accelerated voltage decay characteristics This is generally recognised by battery makers as the best method to determine whether the battery continues to meet its published capacity rating. However, this method is time-consuming and can also exacerbate battery deterioration. Frequent testing of the battery using a discharge capacity test leaves the system vulnerable as the battery is depleted and cannot then be ready for an emergency event.

Accepted testing intervals for load cycle testing are generally annually, reducing to semi-annually after degradation is observed. This method is expensive, logistically challenging for larger banks and time consuming. These issues serve to preclude the more frequent use of the technique for condition monitoring.

It is known that battery impedance measurements can provide an indication of battery condition.

Various arrangements for lighting systems are known which provide both conventional and emergency lighting. As mentioned above, in emergency lighting systems, the battery condition is critical to the safety provided by such systems.

Such emergency lighting is intended to be activated when the conventional lighting is no longer operative because the direct mains supply to the conventional lighting is no longer available or malfunctions. Emergency lighting is typically powered by a battery. Conventional lighting is controlled by an on/off switch by means of which a user (or control system) can control whether the lighting is illuminated or not. Generally, emergency lighting is intended to be automatically illuminated when the absence of mains power or the malfunction of mains power for the conventional lighting is detected in some way. Emergency lighting may be used to allow escape from buildings that would otherwise be in darkness due to the inoperativeness of the conventional lighting.

Emergency lighting and conventional lighting may share components. For example, the same lamp (such as a gas discharge lamp or LED) and/or ballast may be used for both conventional and emergency lighting ("maintained mode"). Other components may also be shared.

A lighting system comprising emergency lighting and conventional lighting may be considered to have two operating modes. In a normal mode, when the direct mains supply is operating normally (within the normal voltage range), a switched mains input, controlled by an on/off switch, is monitored, and the lamp is illuminated or extinguished in dependence upon the switched mains input In an emergency mode, when the mains supply is not available or is malfunctioning (is outside the normal voltage range), the lamp is illuminated automatically, irrespective of the status of the switched mains input, using power from a battery or other storage element.

An object of the embodiment of the present invention, to be described in detail, is to provide an improved battery condition monitoring system and method that can, for example, be used to monitor the condition of the battery of the emergency lighting system.

SUMMARY OF THE INVENTION

The above object is achieved by the battery condition monitoring system according to independent claim 1 and the method according to independent claim 4. Additional features of the invention are presented in the dependent claims.

In one aspect, the present invention provides a power supply including a battery and a battery condition monitoring system as defined above and/or operable in accordance with the method as defined above, and further including alerting means to provide an alert when it is determined that the battery condition is unsatisfactory. This advantageously may prompt a user to perform timely replacement of the battery.

It may be possible that the frequency of periodic testing can be increased when the cell becomes aged. This means that the frequency of periodic testing can be held low with a new cell but could be increased with increasing age of the cell.

Embodiments comprise a system and method to evaluate the reduction of battery energy storage capacity (due to degrading and/or aging) based on the measurement of a battery's series equivalent impedance. The embodiments enable the implementation of several intelligent functions related to the battery management such as consumer's warning on product future failure.

The battery impedance measurement method of the embodiment provides a battery management system that can evaluate and/or predict the battery cell(s) energy storage capacity and degrading based on the principle that an increase on the battery series impedance occurs during the cell(s) life time whilst the cell(s) energy storage capacity (Ah) reduces.

In many battery cell(s) types, such as Nickel-Metal Hybrid (NiMh), the internal impedance increase with aging. This effect occurs before the major loss of capacity, being a precursor to the battery failure, so potentially giving the consumer a warning that within a certain time the device will fail.

The embodiment may provide the following:

1. A method that associates the battery equivalent series impedance to its energy storage capacity, enabling the evaluation of its status of aging and/or degrading.

2. A method by which the series battery impedance measurement is taken in order to detect the battery aging and/or loss of its energy storage capacity.

3. A method that compares the battery equivalent series impedance at the device's early life and periodically afterwards to evaluate the loss of energy storage capacity and/or its aging.

4. A way of evaluating the loss of battery energy storage capacity and/or its aging based on the increase on its series equivalent impedance during the battery life time.

5. A method that associates the battery series impedance increasing with Ni-Mh battery aging.

6. A method that enables early consumer warnings for battery/device failure based on its equivalent series impedance value.

The term "battery" used herein includes a device comprising an electric cell, i.e. a device that produces electricity from a chemical reaction. The term "battery" includes devices comprising two or more cells connected in series or parallel, and also devices comprising only a single cell. A cell generally consists of a negative electrode; an electrolyte, which conducts ions; a separator, also an ion conductor; and a positive electrode.

BRIEF DESCRIPTION OF THE DRAWINGS

For a better understanding of the present invention an embodiment will now be described by way of example, with reference to the accompanying drawings, in which:

Figure 1 shows a simplified equivalent circuit of a battery;

Figure 2 is a graph which shows the variation in battery impedance (vertical axis) against a lapsed time in weeks (horizontal axis);

Figure 3 is a graph which shows the variation in battery capacity (vertical axis) against a lapsed time in weeks (horizontal axis);

Figure 4A shows the battery current (vertical axis) against time (horizontal axis) when a battery is initially charged and then immediately subsequently discharged for the purpose of performing the battery impedance measurement;

Figure 4B shows the battery voltage (vertical axis) against time (horizontal axis) variation caused by the charging and discharging of Figure 4A over the identical time period (horizontal axis); and

Figure 5 shows a schematic drawing of a battery condition monitoring system used in an emergency lighting apparatus which incorporates a battery monitoring system in accordance with an embodiment of the present invention.

In the drawings like elements are generally designated with the same reference sign.

DETAILED DESCRIPTION OF EMBODIMENT OF THE INVENTION

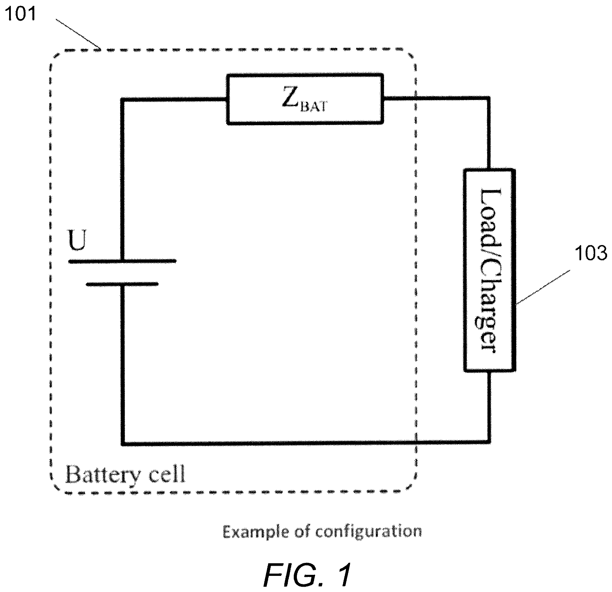

A simplified equivalent circuit of the battery 101, represented by a fixed voltage source and its equivalent series impedance with the connection of a load or charger 103, is presented in figure 1.

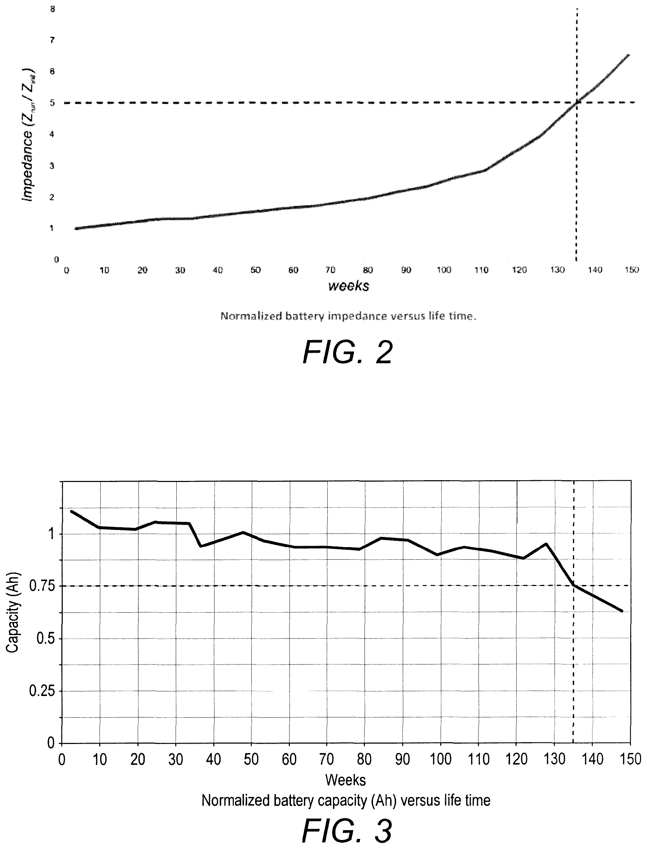

By using the measurement or assumption (based upon battery manufacturer/supplier information) of battery initial impedance, a battery failure can be predicted from battery data curves that can be illustrated theoretically by figures 2 and 3. Figure 2 shows the battery impedance through lifetime by initial measurement variation versus number of weeks of elapsed time and figure 3 shows the cell capacity (normalized by nominal condition) versus number of weeks of elapsed time.

The embodiment proposes the periodical track of the battery internal equivalent series impedance during battery lifetime, comparing actual measurements to early life (initial usage phase), impedance values (measured or assumed) in order to evaluate the current status of the device energy storage capacity.

**Impedance Measurement**

Several methods can be applied for measuring the battery series impedance based upon applying charging and/or discharging currents and measuring the cell's voltages. As it is expected a low magnitude impedance (mW range) for most battery chemistries and possible bidirectional mentioned battery driving (charge and discharge), one way to accurately measure such impedance is to apply a charging current for a specified time, measuring the battery voltage and, straight after (preferably immediately subsequently), change to a discharge current, measuring again the voltage across the cell. The voltage difference $\Delta U_{satt}$ measured straight after the inversion divided by the sum of the charge and discharge currents, $I_{Charge}$ and $I_{Discharge}$, defines the magnitude of the battery impedance ($Z_{Bat}$) as shown in (1).

$$Z_{Bat} = \frac{\Delta U_{Batt}}{I_{Charge} + I_{Discharge}}$$

$$(1)$$

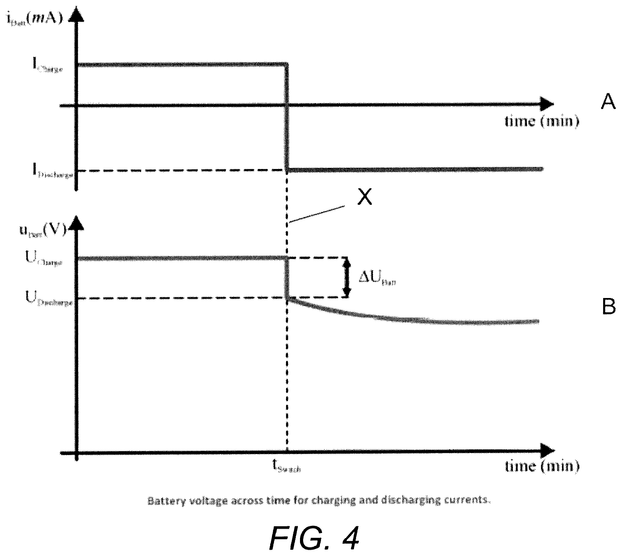

The graph of figure 4 illustrates the basic principle for battery impedance measurement by showing the theoretical voltage and current waveforms in the battery during charging/discharging. It can be seen that, when the current ($i_{Batt}$) is reversed from charging to discharging state (at X), the battery voltage ($u_{Batt}$) immediately reduces its value because of the voltage drop in the battery impedance (resistance, in fact). Alternatively to that, discharge to charge transition or only charge or discharge current with correspondent comparison to null current can be used for measure voltage and calculate the impedance, however with lower accuracy. Open and short circuit (almost) can be also applied to the battery for evaluate its resistance as a further alternative indication of impedance. Other impedance measuring or estimating methods may also be used.

Figures 2 and 3 illustrate an example of how such method may be implemented. First of all, a way of accurately measuring the battery impedance and an energy storage capacity curve (similar to figure 3) provided by the battery supplier (or any other source, such as recorded measurement of similar battery) are assumed.

The impedance is measured or its value assumed according to supplier information at the beginning of the battery life time (during the initial battery usage phase). Then, periodical or random measurements of the impedance, perhaps starting after (e.g.) some weeks, are performed and the current measurement is compared to the impedance magnitude at early life stages (initial usage phase).

A certain level of energy storage capacity limit is set; in this case, 75% of the cell's initial capacity. As can be seen in figure 3, the cell of this example reaches 75% of its initial capacity at approximately 135 weeks from the initial usage phase. From figure 2, it can be concluded that the battery series impedance in this time is 5 times the initial early life (initial battery usage phase) impedance (full capacity).

Therefore, a management system can interpret impedance magnitudes higher than 5 times early the initial impedance as indicating energy storage capacity lower than 75% of the nominal. That information, together with the supplier curves, can be used to predict when the storage capacity will reach unacceptable levels to warn the user/consumer or the periodical information send to a central management that permanently indicates the capacity of all system cells or be used in any way the battery management designer wishes.

Since storage capacity testing (load cycle testing) can typically occur only once (or twice) per year, the value of the impedance increase will give the customer valuable information about the status of the cells typically before a storage capacity test actually fails. The frequency of the storage capacity testing can be increased over the life time of the cells.

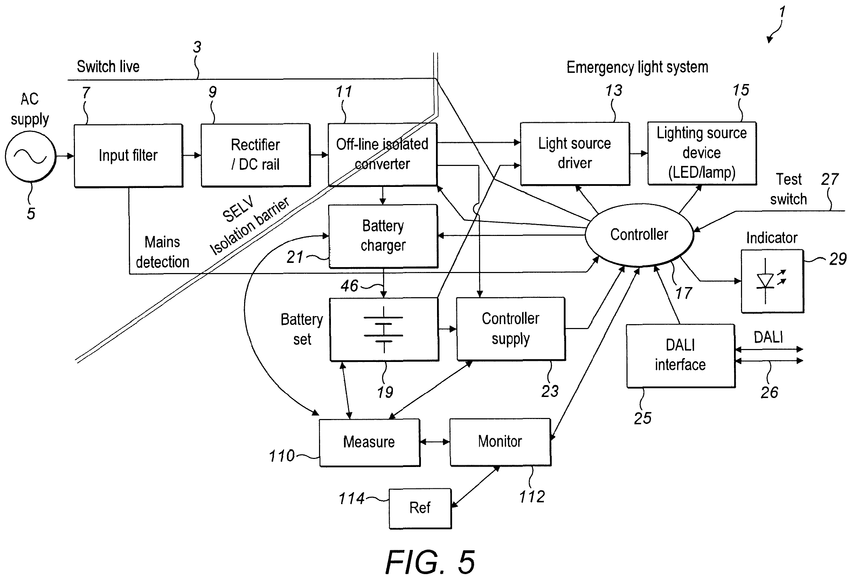

An embodiment will be described in more detail in the context of an emergency lighting system as shown in Figure 5.

Figure 5 shows the basic known elements of such a known lighting system, designated generally at 1, which receives the switched mains input 3 and the direct AC mains input 5. The direct AC mains input 5 is filtered by input filter 7 (for harmonics, EMI, and power factor reasons) and rectified by rectifier 9 to which a SELV (Separated Extra Low Voltage) isolated DC-DC input converter 11 is connected.

The lighting system further comprises a light source driver 13 (e.g. electronic ballast) and a light source 15 (e.g. LED lamp) powered by the input converter 11.

An electronic controller 17 controls the operation of the lighting system, including activating emergency lighting when appropriate.

Figure 5 further shows a battery 19 which provides power in an emergency situation. Battery power is applied to the driver 13 and light source 15 when the controller 17 detects the failure of the mains supply 5.

The same light source driver 13 is used both in the emergency mode and the normal mode to supply current to the lamp 15 in this example, although this is not essential. The emergency mode is activated by the controller 17 when the direct mains input 5 is not available or malfunctions. The normal mode should be activated by the controller 17 when the direct mains 5 is present and operating correctly, and in this mode the lamp 15 is illuminated when the switched mains 3 is on.

The controller 17 is powered by a controller supply 23, which itself is powered by the input converter 11. The controller supply 23 may be a Low Voltage Power Supply (LVPS).

When the direct mains input 5 is a normal AC mains signal the battery 19 is charged from the input converter 11 by battery charger 21 (via charger rail 46) under control of the controller 17.

In more detail, the input converter 11 receives the direct mains input voltage 5 and provides DC output to supply current to the light source driver 13 and battery charger 21. The input converter 11 is advantageously an isolated converter and may be an SELV isolated converter. The switched mains input 3 is monitored either directly or indirectly by the controller 17. The controller 17 also determines whether or not the direct mains input 5 is operating normally.

When the controller 17 determines that the direct mains 5 is operating normally and that the switched mains input 3 is on, the electronic controller 17 activates the light source driver 13 to illuminate the lamp 15 and activates the battery charger 21 to charge the battery 19.

When the controller 17 detects that the direct mains input 5 is not normal (emergency mode), the controller 17 activates the light source driver 13 using power from the battery 19 to illuminate the lamp 15 (irrespective of the status of the switched mains input 3).

When in the normal mode the electronic controller 17 may operate the light source driver 13 in a different manner to the emergency mode.

The lighting system 1 may comprise an interface 25, e.g. a DALI (Digital Addressable Lighting Interface), that is connected to a DALI bus 26, for intensity control (dimming) and / or for maintenance and service control. DALI is a communication protocol widely used in lighting systems. A two wire serial communication arrangement establishes a master/slave communication between a central DALI controller (not shown) and the lighting system controller 17 by setting low and high levels of voltages. Data is transferred between the DALI controller and lighting system controller, by means of an asynchronous, half-duplex, serial protocol over a two-wire differential bus, with a fixed data transfer rate of 1200 bit/s. The DALI data is transmitted using Manchester encoding. The protocol standard sets high levels as voltage differences high at 9.5V (either positive or negative) between the two wires. Low levels are set as voltage differences of less than 6.5V. According to the protocol the current supply for the DALI communication has to be limited to 250mA. The interface 25 may be formed by any digital interface where the DALI interface is described herein only as one example.

Depending on the type of mains voltage detected on the direct mains input 5, the controller 17 may put the driver 13 into different operation modes, e.g. to illuminate the lamp 15 at a given intensity level. The different types of operation depending on the type of detected mains voltage may be also programmed in the controller 17 and may be changed (e.g. by the DALI controller) through an interface (e.g. DALI interface). For example the dimming range can be limited due to the detected type of mains voltage or a certain dimming level can be selected (e.g. in emergency mode).

The lighting system may additionally include a test switch 27 (to exercise auto-test routines) and a status indicator LED 29, connected to the controller 17.

Additionally, in accordance with the embodiment, the emergency lighting system of Figure 5 further includes a measurement unit 110 that is coupled to the battery 19, the battery charger 21 and the controller supply 23. The measurement unit 110 is operable to obtain an indication of impedance of the battery 19 by any suitable method, for example by one of the impedance measurements described above.

The system further includes a monitoring unit 112. The monitoring unit 112 controls operation of the measuring unit 110 and, particularly, causes periodic operation of the measuring unit 110 to obtain an indication of the impedance of the battery 19. The system additionally includes a reference impedance value store 114 for storage a reference impedance value of the battery 19. The reference impedance value may be obtained by measurement or may be a pre-set value.

The monitoring unit 112 may be connected to the controller 17. Battery condition information may be communicated from the monitoring unit 112 to the controller 17. The controller 17 may use information from the monitoring unit 112 to alert the consumer to a deteriorated condition of the battery 19, for example by the status indicator LED 29. Further, the connection between the controller 17 and the monitoring unit 112 may be used to store a pre-set reference impedance value in the reference impedance value store 114 (which value may, for example, be communicated via the DALI interface 25 and DALI bus 26).

The monitoring unit 112, although shown as a separate entity in Figure 5, may be integrated into the controller 17.

When the battery 19 of the emergency lighting system 1 is new a reference impedance value may be obtained by the monitoring unit 112 signalling to the measuring unit 110 to measure the impedance of the battery 19. The impedance value is then stored in the impedance value reference store 114 after being communicated from the measuring unit 110 to the monitoring unit 112. Alternatively, the reference impedance value stored in the reference impedance value store 114 may be a pre-set or predetermined value that is obtained from a suitable source, such as the manufacturer of the battery 19. In either case, the reference impedance value stored in the reference impedance value store 114 provides an indication of the impedance value of the battery during an initial usage phase - that is, a phase before significant deterioration of the battery occurs (for example, in the first five percent of the normal life span of the battery).

The emergency lighting system 1 operates in the normal manner. The battery 19 is charged in the normal mode by the battery charger 21 and is discharged in the emergency mode in order to illuminate the light source 15 constantly to allow safe evacuation of the building protected by the emergency light system 1.

The monitoring unit 112 is operable to periodically measure the impedance of the battery 19 using a suitable impedance measuring method, such as one of those described above. Measurement intervals may be random, may be regularly spaced apart, or may be spaced apart according to a different scheme. For example, the time between successive impedance measurements may be reduced as the battery impedance increases (and the point at which the battery should be replaced nears). Measuring the battery impedance for two weeks or so is currently considered to be a suitable measurement interval for most applications.

In order to perform an impedance measurement, the monitoring unit 112 activates the battery charger 21 for a time period, and then deactivates the battery charger 21 and immediately after causes discharge of the battery 19 for a time period - for example by means of the controller supply 23. This causes the current reversal and voltage variations of the type described above in relation to Figure 4, and from which the impedance can be derived.

When an impedance measurement is made by the monitoring unit 112 this is compared to the reference impedance value stored in the reference impedance store 114.

The monitoring unit 112 is provided with a threshold amount with which the measured impedance value is compared. The reference amount may be a multiple of the reference impedance value. If the battery 19 deteriorates in the manner of the graphs of Figures 2 and 3, the threshold amount may suitably be five times the reference impedance value. The threshold amount of five times is just an example and may vary depending upon the type of cells. That is, the monitoring unit 112 determines whether the measured impedance value exceeds five times the reference impedance value. If it is determined that the measured impedance value exceeds the threshold amount, this is an indication that the battery has deteriorated to a maximum acceptable amount (it has only 75% of its initial capacity) and is no longer suitable for use in the emergency lighting system 1.

Accordingly, the consumer may be alerted to this deterioration of the battery 19 - for example, via the controller 17 and LED lamp 29 or by communication via the DALI interface 25 and DALI bus 26 from the controller 17 to a central DALI controller, e.g. as a part of a central management (or any other way). The consumer can then take action to replace the battery 19.

Further, as the measured impedance increases, this may be communicated to the consumer so that the consumer is forewarned of the need to replace the battery 19 in the future. The measured impedance value can be used by the monitoring unit 1 12 to predict the time when the battery 19 will have deteriorated beyond acceptable limits, using impedance data from the graph of Figure 2, and the date on which the battery 19 may be predicted to require replacement can communicated it to the consumer.

If the relationship between impedance and capacity of the battery 19 is different from that shown in Figures 2 and 3, then a different threshold amount may be used, according to the circumstances. The threshold amount may not be a multiple of the reference impedance, and may be calculated on some other basis. The connection between the controller 17 and the monitoring unit 112 may be used to provide or change the threshold amount (which value may, for example, be communicated via the DALI interface 25 and DALI bus 26).

The reference impedance value may be a pre-set impedance value that is expected to correspond to the battery capacity being reduced by a maximum amount (e.g. to 75% of its capacity when new). In this arrangement, a threshold amount is not required: the monitoring means 112 may compare the measured impedance value with the pre-set reference impedance value to determine the capacity status of the battery.

The example shown in Figure 5 is only one example of an emergency lighting system. Other systems may exist where the maintained converter connected to switched live is a separate device. The light source driver 13 may be used in the emergency mode to supply current to the lamp 15 in this example, although this is not essential. An additional driver may supply current to the lamp in the normal mode and such additional driver may be disconnected from the lamp by light source driver 13 in case of an emergency mode (e.g. by the use of a relay).

The effect of cabling and connections associated with the battery on the measured impedance can be minimised by applying an algorithm that interprets that battery aging based on impedance evaluations compared to a first measurement (initial impedance) taken when the battery is installed. The system would then interpret the updated measured and calculated values looking at how much the impedance has increased if compared to the first measurement. The effect of cabling and connections is not automatically compensated for if a predetermined or pre-set reference value is used - but an adjustment to such a predetermined or pre-set reference value could be made to provide compensation.

## Claims

1.    A battery condition monitoring system for an emergency lighting system (1) including:

measuring means (110) connectable to a battery (19) and operable to obtain an indication of an impedance of the battery (19);
reference impedance value storage means (114) for storing a reference impedance value of the battery (19); and
monitoring means (112) configured to operate a battery charger (21) connectable to the battery condition monitoring system and periodically operate the measuring means (110) to obtain the indication of the impedance of the battery (19), the monitoring means (112) further configured to compare the indication of the impedance of the battery (19) to the reference impedance value, and to estimate the battery condition in dependence thereon;
wherein the measuring means (110) is operable to provide the reference impedance value by being connected to the battery (19) during an initial usage phase of the battery (19) to acquire an initial indication of the impedance thereof during the initial usage phase, or wherein the reference impedance value is an estimation of the impedance of the battery (19) during an initial usage phase;

**characterized in that**
in order to perform an impedance measurement:

the monitoring means (112) is configured to
activate the battery charger (21) to apply a charge current to the battery (19) for a first time period, and then deactivate the battery charger (21) and, immediately after, cause discharge of the battery (19) by a discharge current for a second time period, and
the measuring means (110) is configured to measure a first voltage of the battery (19) while the charge current is applied,
measure a second voltage of the battery (19) straight after the inversion from charging to discharging,
calculate a voltage drop straight after inversion from charging to discharging as a voltage difference between the second voltage and the first voltage, and
divide the voltage drop across the battery straight after inversion from charging to discharging by a sum of the charge and discharge currents, thereby obtaining the indication of the impedance of the battery (19).

2.    The system of claim 1, wherein the monitoring means (112) is operable to determine if the obtained indication of battery impedance exceeds the reference impedance value by a predetermined threshold amount.

3.    The system of claim 2, wherein the threshold amount is five times the reference impedance value.

4.    A method of estimating battery condition, including

periodically performing a measurement to obtain an indication of an impedance of the battery (19); and
comparing the impedance of the battery (19) to a reference impedance value to estimate the battery condition,

wherein the reference impedance value is obtained by performing a measurement to acquire an indication of the impedance of the battery (19) during an initial usage phase of the battery (19), or wherein the reference impedance value is an estimation of the impedance of the battery (19) during an initial usage phase,

**characterized by**
in order to perform an impedance measurement:

activating a battery charger (21) to apply a charge current to the battery (19) for a first time period, and then deactivating the battery charger (21) and, immediately after, causing discharge of the battery (19) by a discharge current for a second time period,
measuring a first voltage of the battery (19) while the charge current is applied,
measuring a second voltage of the battery (19) straight after the inversion from charging to discharging,
calculating a voltage drop straight after inversion from charging to discharging as a voltage difference between the second voltage and the first voltage, and
dividing the voltage drop across the battery straight after inversion from charging to discharging by a sum of the charge and discharge currents, thereby obtaining the indication of the impedance of the battery (19).

5. The method of claim 4, including determining if the measured battery impedance exceeds the reference impedance value by a predetermined threshold amount.

6. The method of claim 5, wherein the predetermined threshold amount is five times the reference impedance value.

7. The method of any one of claims 4 to 6, including performing the measurement to obtain the indication of battery impedance at a plurality of spaced apart time intervals.

8. The method of any one of claims 4 to 7, further including performing a periodic battery capacity test.

9. A power supply for an emergency lighting system (1) including a battery (19) and a battery condition monitoring system (110, 112, 114) according to any one of claims 1 to 3 and/or configured to be operated in accordance with the method of any one of claims 4 to 8, and further including alerting means configured to provide an alert when it is determined that the battery condition is unsatisfactory.

10. Emergency lighting system (1) including a power supply according to claim 9 and a light source (15) configured to be powered by the power supply.

**Patentansprüche**

1. Batteriezustandsüberwachungssystem für ein Notbeleuchtungssystem (1), einschließlich:

ein Messmittel (110), das mit einer Batterie (19) verbindbar ist und betreibbar ist, um eine Angabe einer Impedanz der Batterie (19) zu erhalten;
ein Referenzimpedanzwert-Speichermittel (114) zum Speichern eines Referenzimpedanzwerts der Batterie (19); und
ein Überwachungsmittel (112), das konfiguriert ist, um ein Batterieladegerät (21) zu betreiben, das mit dem Batteriezustandsüberwachungssystem verbindbar ist, und periodisch das Messmittel (110) zu betreiben, um die Angabe der Impedanz der Batterie (19) zu erhalten, wobei das Überwachungsmittel (112) ferner konfiguriert ist, um die Angabe der Impedanz der Batterie (19) mit dem Referenzimpedanzwert zu vergleichen und den Batteriezustand in Abhängigkeit davon zu schätzen;
wobei das Messmittel (110) betreibbar ist, um den Referenzimpedanzwert bereitzustellen, indem es während einer anfänglichen Gebrauchsphase der Batterie (19) mit der Batterie (19) verbunden wird, um eine anfängliche Angabe ihrer Impedanz während der anfänglichen Gebrauchsphase zu erhalten, oder wobei der Referenzimpedanzwert eine Schätzung der Impedanz der Batterie (19) während einer anfänglichen Gebrauchsphase ist;
**dadurch gekennzeichnet, dass**
um eine Impedanzmessung durchzuführen:

das Überwachungsmittel (112) konfiguriert ist, um das Batterieladegerät (21) zu aktivieren, um einen Ladestrom für einen ersten Zeitraum an die Batterie (19) anzulegen, und dann das Batterieladegerät (21) zu deaktivieren und unmittelbar danach eine Entladung der Batterie (19) durch einen Entladestrom für einen zweiten Zeitraum zu bewirken, und
das Messmittel (110) konfiguriert ist, um

eine erste Spannung der Batterie (19) zu messen, während der Ladestrom angelegt wird,
eine zweite Spannung der Batterie (19), genau nach der Inversion von Laden zu Entladen, zu messen,
einen Spannungsabfall, genau nach der Inversion von Laden zu Entladen als eine Spannungsdifferenz zwischen der zweiten Spannung und der ersten Spannung zu berechnen, und
den Spannungsabfall über der Batterie, genau nach der Inversion von Laden zu Entladen durch eine Summe der Lade- und Entladeströme zu teilen, wodurch die Angabe der Impedanz der Batterie erhalten wird (19).

2. System nach Anspruch 1, wobei das Überwachungsmittel (112) betreibbar ist, um zu bestimmen, ob die erhaltene Angabe der Batterieimpedanz den Referenzimpedanzwert um einen vorbestimmten Schwellenbetrag überschreitet.

3. System nach Anspruch 2, wobei der Schwellenbetrag das Fünffache des Referenzimpedanzwerts beträgt.

4. Verfahren zum Schätzen eines Batteriezustands, einschließlich
periodisches Durchführen einer Messung, um eine Angabe einer Impedanz der Batterie (19) zu erhalten; und
Vergleichen der Impedanz der Batterie (19) mit einem Referenzimpedanzwert, um den Batteriezustand zu schätzen, wobei der Referenzimpedanzwert durch Durchführen einer Messung erhalten wird, um eine Angabe der Impedanz der Batterie (19) während einer anfänglichen Gebrauchsphase der Batterie (19) zu erhalten, oder wobei der Referenzimpedanzwert eine Schätzung der Impedanz der Batterie (19) während einer anfänglichen Gebrauchsphase ist, **gekennzeichnet durch**
um eine Impedanzmessung durchzuführen:

Aktivieren eines Batterieladegeräts (21), um einen Ladestrom für einen ersten Zeitraum an die Batterie (19) anzulegen, und dann Deaktivieren des Batterieladegeräts (21) und, unmittelbar danach, Bewirken einer Entladung der Batterie (19) durch einen Entladestrom für einen zweiten Zeitraum,
Messen einer ersten Spannung der Batterie (19), während der Ladestrom angelegt wird,
Messen einer zweiten Spannung der Batterie (19), genau nach der Inversion von Laden zu Entladen,
Berechnen eines Spannungsabfalls, genau nach der Inversion von Laden zu Entladen, als eine Spannungsdifferenz zwischen der zweiten Spannung und der ersten Spannung, und
Teilen des Spannungsabfalls über der Batterie, genau nach der Inversion von Laden zu Entladen, durch eine Summe der Lade- und Entladeströme, wodurch die Angabe der Impedanz der Batterie erhalten wird (19).

5. Verfahren nach Anspruch 4, einschließlich das Bestimmen, ob die gemessene Batterieimpedanz den Referenzimpedanzwert um einen vorbestimmten Schwellenbetrag überschreitet.

6. Verfahren nach Anspruch 5, wobei der vorbestimmte Schwellenbetrag das Fünffache des Referenzimpedanzwerts ist.

7. Verfahren nach einem der Ansprüche 4 bis 6, einschließlich das Durchführen der Messung, um die Angabe der Batterieimpedanz in einer Vielzahl von beabstandeten Zeitintervallen zu erhalten.

8. Verfahren nach einem der Ansprüche 4 bis 7, das ferner das Durchführen eines periodischen Batteriekapazitätstests einschließt.

9. Stromversorgung für ein Notbeleuchtungssystem (1), einschließlich eine Batterie (19) und ein Batteriezustandsüberwachungssystem (110, 112, 114) nach einem der Ansprüche 1 bis 3 und/oder konfiguriert, um gemäß dem Verfahren nach einem der Ansprüche 4 bis 8 betrieben zu werden, und ferner einschließend Warnmittel, die konfiguriert sind, um eine Warnung bereitzustellen, wenn bestimmt wird, dass der Batteriezustand nicht zufriedenstellend ist.

10. Notbeleuchtungssystem (1), einschließlich eine Stromversorgung nach Anspruch 9 und eine Lichtquelle (15), die konfiguriert ist, um von der Stromversorgung gespeist zu werden.

**Revendications**

1. Système de surveillance de l'état d'une batterie pour un système d'éclairage de secours (1) incluant :

un moyen de mesure (110) pouvant être connecté à une batterie (19) et opérationnel pour obtenir une indication d'une impédance de la batterie (19) ;
un moyen de stockage de valeur d'impédance de référence (114) pour stocker une valeur d'impédance de référence de la batterie (19) ; et
un moyen de surveillance (112) configuré pour faire fonctionner un chargeur de batterie (21) pouvant être connecté au système de surveillance de l'état d'une batterie et faire fonctionner périodiquement le moyen de mesure (110) pour obtenir l'indication de l'impédance de la batterie (19), le moyen de surveillance (112) configuré en outre pour comparer l'indication de l'impédance de la batterie (19) à la valeur d'impédance de référence et pour estimer l'état de la batterie en fonction de cela ;
dans lequel le moyen de mesure (110) est opérationnel pour fournir la valeur d'impédance de référence en étant connecté à la batterie (19) pendant une phase initiale d'utilisation de la batterie (19) pour acquérir une indication initiale de l'impédance de celle-ci pendant la phase initiale d'utilisation ou dans lequel la valeur d'impédance de référence est une estimation de l'impédance de la batterie (19) pendant une phase initiale d'utilisation ;
**caractérisé en ce que**
afin de mettre en oeuvre une mesure d'impédance :

le moyen de surveillance (112) est configuré pour activer le chargeur de batterie (21) pour appliquer un courant de charge à la batterie (19) pendant une première période de temps, puis désactiver le chargeur de batterie (21) et, immédiatement après, provoquer une décharge de la batterie (19) par un courant de décharge pendant une deuxième période de temps, et
le moyen de mesure (110) est configuré pour

mesurer une première tension de la batterie (19) alors que le courant de charge est appliqué,
mesurer une deuxième tension de la batterie (19) juste après l'inversion de la charge à la décharge,
calculer une chute de tension juste après inversion de la charge à la décharge en tant que différence de tension entre la deuxième tension et la première tension et
diviser la chute de tension à travers la batterie juste après inversion de la charge à la décharge par une somme des courants de charge et de décharge, ce qui permet d'obtenir l'indication de l'impédance de la batterie (19).

2. Système selon la revendication 1, dans lequel le moyen de surveillance (112) est opérationnel pour déterminer si l'indication obtenue d'impédance de batterie dépasse la valeur d'impédance de référence d'une quantité seuil prédéterminée.

3. Système selon la revendication 2, dans lequel la quantité seuil vaut cinq fois la valeur d'impédance de référence.

4. Procédé d'estimation de l'état d'une batterie, incluant
la mise en oeuvre périodique d'une mesure pour obtenir une indication d'une impédance de la batterie (19) ; et
la comparaison de l'impédance de la batterie (19) à une valeur d'impédance de référence pour estimer l'état de la batterie,
dans lequel la valeur d'impédance de référence est obtenue en mettant en œuvre une mesure pour acquérir une indication de l'impédance de la batterie (19) pendant une phase initiale d'utilisation de la batterie (19) ou dans lequel la valeur d'impédance de référence est une estimation de l'impédance de la batterie (19) pendant une phase initiale d'utilisation,
**caractérisé par**
afin de mettre en œuvre une mesure d'impédance :

l'activation d'un chargeur de batterie (21) pour appliquer un courant de charge à la batterie (19) pendant une première période de temps, puis la désactivation du chargeur de batterie (21) et, immédiatement après, le fait de provoquer une décharge de la batterie (19) par un courant de décharge pendant une deuxième période de temps,
la mesure d'une première tension de la batterie (19) alors que le courant de charge est appliqué,
la mesure d'une deuxième tension de la batterie (19) juste après l'inversion de la charge à la décharge,
le calcul d'une chute de tension juste après inversion de la charge à la décharge en tant que différence de tension entre la deuxième tension et la première tension et

la division de la chute de tension à travers la batterie juste après inversion de la charge à la décharge par une somme des courants de charge et de décharge, ce qui permet d'obtenir l'indication de l'impédance de la batterie (19).

5. Procédé selon la revendication 4, incluant le fait de déterminer si l'impédance de batterie mesurée dépasse la valeur d'impédance de référence d'une quantité seuil prédéterminée.

6. Procédé selon la revendication 5, dans lequel la quantité seuil prédéterminée vaut cinq fois la valeur d'impédance de référence.

7. Procédé selon l'une quelconque des revendications 4 à 6, incluant la mise en œuvre de la mesure pour obtenir l'indication d'impédance de batterie à une pluralité d'intervalles de temps espacés.

8. Procédé selon l'une quelconque des revendications 4 à 7, incluant en outre la mise en œuvre d'un test périodique de capacité de batterie.

9. Alimentation électrique pour un système d'éclairage de secours (1) incluant une batterie (19) et un système de surveillance de l'état de la batterie (110, 112, 114) selon l'une quelconque des revendications 1 à 3 et/ou configuré pour être exploité conformément au procédé selon l'une quelconque des revendications 4 à 8 et incluant en outre un moyen d'alerte configuré pour fournir une alerte lorsqu'il est déterminé que l'état de la batterie n'est pas satisfaisant.

10. Système d'éclairage de secours (1) incluant une alimentation électrique selon la revendication 9 et une source de lumière (15) configurée pour être alimentée par l'alimentation électrique.

101

$Z_{BAT}$

U

Load/Charger

103

Battery cell

Example of configuration

*FIG. 1*

Normalized battery impedance versus life time.

## FIG. 2

Normalized battery capacity (Ah) versus life time

## FIG. 3

Battery voltage across time for charging and discharging currents.

*FIG. 4*

FIG. 5

EP 2 837 258 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 3224671 A1
- FR 2622749 A1
- US 6313609 B1
- US 2011267000 A1
- GB 2088159 A
- GB 2271229 A
- US 2007046261 A1